# EUROPEAN PATENT SPECIFICATION

(11) **EP 4 165 666 B1**
(45) Date of publication and mention of the grant of the patent: **09.12.2026**
(21) Application number: 21826874.6
(22) Date of filing: 15.06.2021
(51) Int. Cl.: H10W 70/40, H10W 72/50, H10W 74/10, H10W 90/00

(54) **LEADFRAME CAPACITORS**
LEITERRAHMENKONDENSATOREN
CONDENSATEURS DE GRILLE DE CONNEXION

(30) Priority: 15.06.2020 US 202016901310
(43) Date of publication of application: 19.04.2023
(73) Proprietor: Texas Instruments Incorporated, Dallas, TX 75265-5474 (US)
(72) Inventor: KHANOLKAR, Vijaylaximi, Pune (IN); NASUM, Sreeram, Subramanyam, Bangalore 100 (IN); SINGH, Tarunvir, Jalandhar Punjab 144 003 (IN)
(74) Representative: Zeller, Andreas
(86) International application number: PCT/US2021/037410
(87) International publication number: WO 2021/257547

(56) References cited:
- US-A- 4 714 952
- US-A- 5 444 600
- US-A1- 2008 278 255
- US-A1- 2014 253 227
- US-A1- 2016 133 373
- US-A1- 2016 284 631
- US-A1- 2019 237 394
- US-B1- 9 165 873

## Description

### BACKGROUND

Signal isolation is used in various applications where signaling must cross an isolation barrier, for example, between circuits of different voltage domains. Integrating isolation components into fabricated semiconductor dies uses silicon dioxide as the dielectric material for a capacitive isolation barrier with galvanic isolation, and this integration adds cost and complexity to the manufacturing process. Capacitors are formed within silicon metal layers during silicon wafer fabrication process and the capacitor structure depends on the specific fabrication process node geometry and design rules. In addition, a device design often can only be manufactured using a subset of process nodes with qualified isolation components at a given fabrication facility. Isolation qualification and certification is needed for structures fabricated with each of the specified process nodes, resulting in high cost. Integrated isolation components often require special development by process teams and often employ special design rules. Some applications may use wafer fabrication processes optimized for specific needs like high power and/or high voltage, but these processes may not be compatible with robust isolation dielectric requirements. A new design often cannot utilize processes optimized for specific needs such as power and high voltage without redesign of isolation components for those fabrication process nodes, followed by isolation requalification and certification. Moreover, integrating isolation components in a semiconductor wafer fabrication can lead to relatively large minimum die size for an isolation die.

US 2008/0278255 discloses a RF-coupled digital isolator; US 2016/133373 discloses non-planar inductive electrical elements in a semiconductor package lead frame; US 2019/237394 relates to a package structure of a capacitive coupling isolator; US 5,444,600 relates to a lead frame capacitor and capacitively-coupled isolator circuit using the same.

### SUMMARY

In one aspect, an electronic device includes isolation structures created using a patterned lead frame during IC manufacturing to provide a low cost compact isolation solution that does not impact semiconductor wafer fabrication processes and does not require extra board level components. In one example, an electronic device includes a package structure with conductive leads, first and second dies in the package structure, as well as first and second conductive plates electrically coupled to the respective first and second dies and having respective first and second sides spaced apart from and directly facing one another with a portion of the package structure extending between the first side of the first conductive plate and the second side of the second conductive plate to form a capacitor. No other side of the first conductive plate directly faces a side of the second conductive plate, and no other side of the second conductive plate directly faces a side of the first conductive plate.

The first side of the first conductive plate extends in a first plane, the second side of the second conductive plate extends in a second plane, and the first and second planes are parallel to one another. The first and second conductive plates are coplanar in a third plane that is perpendicular to the first and second planes. In one implementation, the package structure has first and second opposite sides spaced apart from one another along a first direction, and the conductive leads are spaced apart from one another along a perpendicular second direction, where the second side of the second conductive plate is spaced apart from the first side of the first conductive plate along one of the first and second directions.

In another example, the second side of the second conductive plate is spaced apart from the first side of the first conductive plate along a third direction that is perpendicular to the first and second directions. In one implementation, the first conductive plate has a first portion having the first side, and a second portion; and the first and second portions of the first conductive plate are non-coplanar. In one example, moreover, the second conductive plate has a first portion having the second side, and a second portion; and the first and second portions of the second conductive plate are non-coplanar. In another example, the electronic device further includes an embedded dielectric insert in the package structure, and the first or second conductive plate is on or in the embedded dielectric insert. In one implementation, multiple conductive plates are on or in the embedded dielectric insert.

Another aspect relates to a method that includes positioning a lead frame, performing connection and molding processes, and a separation process. The lead frame is positioned such that a first side of a first conductive plate is spaced apart from and directly facing a second side of a second conductive plate, where no other side of the first conductive plate directly faces a side of the second conductive plate, and no other side of the second conductive plate directly faces a side of the first conductive plate. The connection process in one example electrically connects a first bond wire to a first die and to the first conductive plate, and electrically connects a second bond wire to a second die and to the second conductive plate. The molding process forms a package structure which encloses the first and second dies, the first and second bond wires and portions of the first and second conductive plates. The separation process separates the first conductive plate, the second conductive plate, and conductive leads from a remaining portion of the lead frame.

In one example, positioning the lead frame includes positioning a first lead frame relative to a second lead frame or relative to a dielectric insert such that the first side of the first conductive plate of the first lead frame is spaced apart from and directly facing the second side of the second conductive plate of the second lead frame or of the dielectric insert. In one implementation, positioning the lead frame includes positioning the first lead frame relative to the dielectric insert such that the first side of the first conductive plate of the first lead frame is spaced apart from and directly facing the second side of the second conductive plate of the dielectric insert. This implementation also includes positioning the second lead frame relative to the dielectric insert such that a first side of a third conductive plate of the second lead frame is spaced apart from and directly facing a second side of a fourth conductive plate of the dielectric insert, where no other side of the third conductive plate directly faces a side of the fourth conductive plate, and no other side of the fourth conductive plate directly faces a side of the third conductive plate.

Another aspect relates to a system having first and second electronic circuits or different voltage domains, as well as an isolation device coupled with the first and second electronic circuits. The isolation device includes a package structure with conductive leads, first and second dies in the package structure, as well as first and second conductive plates electrically coupled to the respective first and second dies and having respective first and second sides spaced apart from and directly facing one another with a portion of the package structure extending between the first side of the first conductive plate and the second side of the second conductive plate to form a capacitor. No other side of the first conductive plate directly faces a side of the second conductive plate, and no other side of the second conductive plate directly faces a side of the first conductive plate.

The first side of the first conductive plate extends in a first plane; the second side of the second conductive plate extends in a second plane, the first and second planes are parallel to one another, and the first conductive plate and the second conductive plate are coplanar in a third plane that is perpendicular to the first and second planes.

In another example, the first conductive plate has a first portion having the first side and a second portion, and the first and second portions of the first conductive plate are non-coplanar.

In another example, the isolation device includes an embedded dielectric insert in the package structure, wherein one of the first conductive plate and the second conductive plate is on or in the embedded dielectric insert.

### BRIEF DESCRIPTION OF THE DRAWINGS

FIG. 1 is a cutaway top plan view of a packaged electronic device with first and second semiconductor dies, and isolation capacitors formed by planar conductive plates from a starting lead frame.
FIG. 2 is a schematic diagram of a circuit implemented in the semiconductor dies and isolation capacitors in the packaged electronic device of FIG. 1.
FIG. 3 is a flow diagram of a method of fabricating a packaged electronic device.
FIGS. 4-7 are partial top plan views of the packaged electronic device of FIG. 1 at different stages of fabrication according to the method of FIG. 3.
FIG. 8 is a perspective view of the packaged electronic device of FIGS. 1, 2 and 4-7.
FIG. 9 is a top perspective view of another example packaged electronic device with first and second semiconductor dies and isolation capacitors with vertically spaced conductive plates from first and second starting lead frames.
FIG. 10 is a top perspective view of first and second starting lead frames used in fabricating the packaged electronic device of FIG. 9.
FIG. 11 is a top perspective view of another example packaged electronic device with first and second semiconductor dies and isolation capacitors with vertically spaced conductive plates from first and second starting lead frames and an insert structure with additional conductive capacitor plates.
FIG. 12 is a top perspective view of first and second starting lead frames and the insert structure used in fabricating the packaged electronic device of FIG. 11.
FIG. 13 is a schematic diagram of a power conversion system with isolated primary and secondary circuits and a control or feedback signal path including the packaged electronic device of FIG. 1.

### DETAILED DESCRIPTION OF EXAMPLE EMBODIMENTS

In the drawings, like reference numerals refer to like elements throughout, and the various features are not necessarily drawn to scale. Also, the term "couple" or "couples" includes indirect or direct electrical or mechanical connection or combinations thereof. For example, if a first device couples to or is coupled with a second device, that connection may be through a direct electrical connection, or through an indirect electrical connection via one or more intervening devices and connections. One or more operational characteristics of various circuits, systems and/or components are hereinafter described in the context of functions which in some cases result from configuration and/or interconnection of various structures when circuitry is powered and operating.

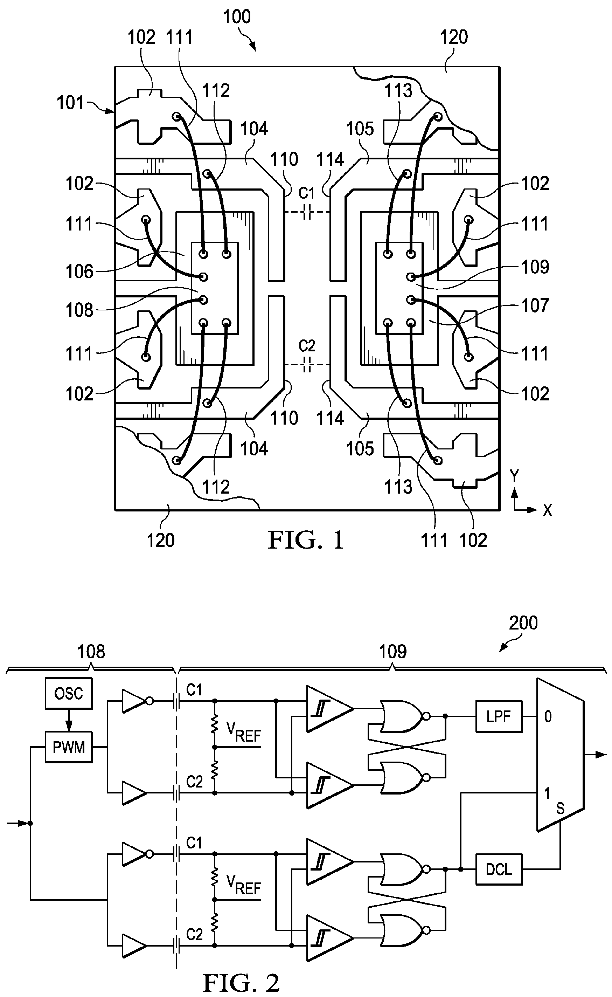

FIG. 1 shows a packaged electronic device 100 with conductive features formed from a starting lead frame 101 (e.g., copper, aluminum, etc.), including conductive leads 102, a pair of first conductive plates 104 and a pair of second conductive plates 105. In another example, only a single first conductive plate 104 and a single second conductive plate 105 are included. In other examples, more than two first conductive plates 104 and more than two respective second conductive plates 105 are included. The electronic device further includes a first die attach pad 106 in a second die attach pad 107, which are also originally part of the starting lead frame 101 during manufacturing. The electronic device 100 includes a first die 108 mounted to the first die attach pad 106, and a second die 109 mounted to the second die attach pad 107. The first conductive plates 104 in this example each include a first side 110. The dies 108 and 109 can be any suitable semiconductor-based circuit die, such as formed using semiconductor processing of a starting wafer, including transistors, resistors, capacitors, or other electronic components integrated into a die structure with conductive features (e.g., copper or aluminum bond pads, etc.) allowing bond wire or flip chip electrical connections.

The electronic device 100 further includes electrical connections between the respective first and second dies 108, 109 and various leads and conductive plates. In the illustrated example, bond wires 111 connect conductive features (e.g., bond pads) of the first die 108 to respective ones of a first set of the conductive leads 102 to make electrical circuit connections with a host printed circuit board (PCB, not shown) to which the electronic device 100 is soldered. Other ones of the bond wires 111 connect conductive features of the second die 109 to a second set of the conductive leads 102. In the illustrated example, the first set of conductive leads 102 that are coupled to the first die 108 are on a first lateral side of the electronic device 100 (e.g., the left side in FIG. 1), and the second set of conductive leads 102 that are coupled to the second die 109 are on an opposite second lateral side of the electronic device 100 (e.g., on the right side in FIG. 1), although not a strict requirement of all possible implementations. The electronic device 100 also includes a pair of first bond wires 112, each of which are coupled between conductive features of the first die 108 and a respective one of the first conductive plates 104. In addition, a pair of second bond wires 113 are each coupled between conductive features of the second die 109 and a respective one of the second conductive plates 105.

The second conductive plates 105 each have a second side 114. The first sides 110 of the respective conductive plates 104 extend in a first plane (e.g., a Y-Z plane in FIG. 1, where the Z direction is out of the page in the drawing). The second sides 114 of the respective second conductive plates 105 extend in a second plane (e.g., also a Y-Z plane), and the first and second planes are parallel to one another. In another example, one or both sides 110 and/or 114 is/are not planar. In the illustrated implementation, the second side 114 of each of the second conductive plates 105 is spaced apart from and directly faces the first side 110 of the respective first conductive plate 104. In addition, no other side of the first conductive plates 104 directly faces a side of the respective second conductive plate 105, and no other side of the respective second conductive plates 105 directly faces a side of the respective first conductive plates 104. Directly facing sides, as used herein, are conductive plate sides that face one another along a straight line with no intervening conductive structures. The electronic device 100 further includes a non-conductive package structure 120. In one example, the package structure 120 is or includes molding compound. A portion of the package structure 120 extends between the first sides 110 of the respective first conductive plates 104 and the second sides 114 of the respective second conductive plates 105 to form respective capacitors C1 and C2 as schematically shown in dashed lines in FIGS. 1. The intervening package structure 120 between the respective plates sides 110 and 114 provides a dielectric which, in conjunction with the conductive material of the respective plates 104 and 105, forms a capacitor structure that operates to isolate first and second circuits of the first and second dies 108 and 109. In operation of the electronic device 100, the example capacitors C1 and C2 provide galvanic capacitive isolation between first and second voltage domains of the respective first and second dies 108 and 109.

In other implementations, a single isolation capacitor is provided in the electronic device 100 using corresponding first and second plates 104 and 105 with respective first and second sides 110 and 114. In other examples, more than two isolation capacitors are provided by arrangement of corresponding sides 110 and 114 of respective first and second plates 104 and 105, in which the first side 110 of the first conductive plate 104 is spaced apart from and directly faces the second side 114 of the second conductive plate 105, and where no other side of the first conductive plate 104 directly faces a side of the second conductive plate 105 and no other side of the second conductive plate 105 directly faces a side of the first conductive plate 104.

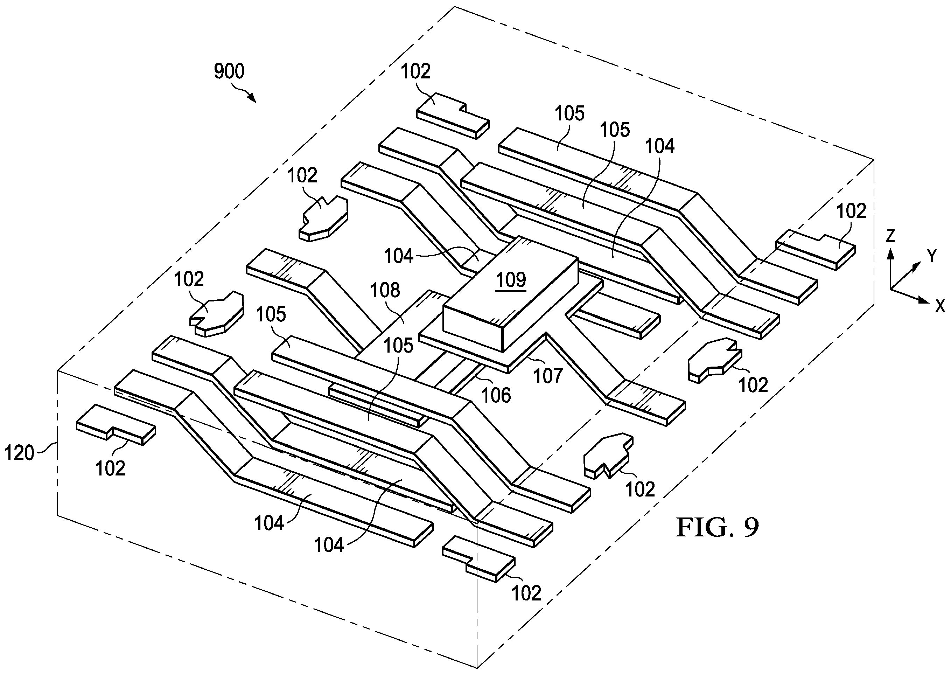

In one example, as shown in FIG. 1, a single starting lead frame 101 is used to create the first and second conductive plates 104 and 105. The first conductive plate 104 and the second conductive plate 105 are coplanar in a third plane (e.g., an X-Y plane) that is perpendicular to the first and second planes of the respective plate faces 110 and 114. In the example of FIG. 1, moreover, the isolation between the respective plates 104 and 105, and between the first and second voltage domains of the respective first and second dies 108 and 109 is provided along a lateral direction. Vertical capacitor plate spacing and isolation directions are provided in other implementations, for example, as illustrated and described below in connection with FIGS. 9-12. In the example of FIG. 1, the package structure 120 has first and second opposite sides along which the respective leads 102 are positioned, where the first and second sides of the package structure 120 are spaced apart from one another along a first direction (e.g., the X direction in FIG. 1), and portions of the conductive leads 102 are exposed outside the package structure 120 along the respective first and second sides of the package structure 120. In one example, the leads are generally flush with the outer sides of the package structure 120 and partially exposed along the bottom and sides, such as for leadless package types including quad flat no lead (QFN) packages or premolded package like MIS, RLF etc. In this example, the conductive leads 102 are spaced from one another along a second direction (e.g., the Y direction in FIG. 1) along the respective first and second sides of the package structure 120, where the second direction Y is perpendicular to the first direction X. In the illustrated example, moreover, the second side 114 of the second conductive plate 105 is spaced apart from the first side 110 of the first conductive plate 104 along the first direction X. In other examples, lateral capacitor plate spacing is possible along a different direction in an X-Y plane, such as along the first (Y) direction.

FIG. 2 shows an isolated communications circuit 200 implemented in the semiconductor dies 108 and 109 and isolation capacitors C1 and C2 in the packaged electronic device 100 of FIG. 1. In certain applications, the capacitors C1 and C2 in FIG. 1 provide a single or multi-channel digital isolator that is created using a custom patterned lead frame 101. In operation, one or more signals are transferred between different voltage domain circuits of the respective first and second dies 108 and 109 using lateral capacitive coupling between lead frame metal areas 104 and 105. The isolated communications circuit 200 includes a high-frequency data channel, for example, with a bandwidth from 100kbps up to 150Mbps, as well as a low-frequency channel, for example, with a bandwidth from DC to 100kbps. In one example implementation, a single-ended input signal entering the high-frequency data channel is split into a differential signal via an inverter gate at the input. The following capacitor-resistor networks differentiate the signal into small and narrow transients, which then are converted into rail-to-rail differential pulses by two comparators. The comparator outputs drive a NOR-gate flip-flop having an output that feeds an output multiplexer. A decision logic (DCL) at the driving output of the flip-flop measures the durations between signal transients. If the duration between two consecutive transients exceeds a certain time limit (e.g., as in the case of a low-frequency signal) the DCL forces the outputmultiplexer to switch from the high-frequency to the low-frequency channel. In one example, the low-frequency input signals are pulse width modulated (PWM) with the carrier frequency of an internal oscillator to create a sufficiently high frequency capable of passing the capacitive barrier. As the input is modulated, a low-pass filter (LPF) removes the high-frequency carrier from the actual data before passing it on to the output multiplexer. In this example, the mold compound or any other encapsulant used in forming the package structure 120 acts as an isolation dielectric barrier with designed isolation spacing to provide a robust high dielectric strength barrier across moisture, temperature, and reliability stress conditions. The starting lead frame 101 can be patterned with and desired custom design for mutual capacitance for circuit performance as needed for a given circuit application. The capacitor isolation can be combined with any process fabrication node for functional silicon or other semiconductor processing that is used to create the dies 108 and 109. In this regard, the lead frame 101 can be tailored to a particular isolation application without changing the fabrication processing used in manufacturing the dies 108 and 109, and the semiconductor die fabrication can be simplified and cost effective compared with integrated isolation component solutions. Moreover, the described examples can be manufactured using existing package assembly processes and equipment, thereby providing a compact cost effective isolation solution.

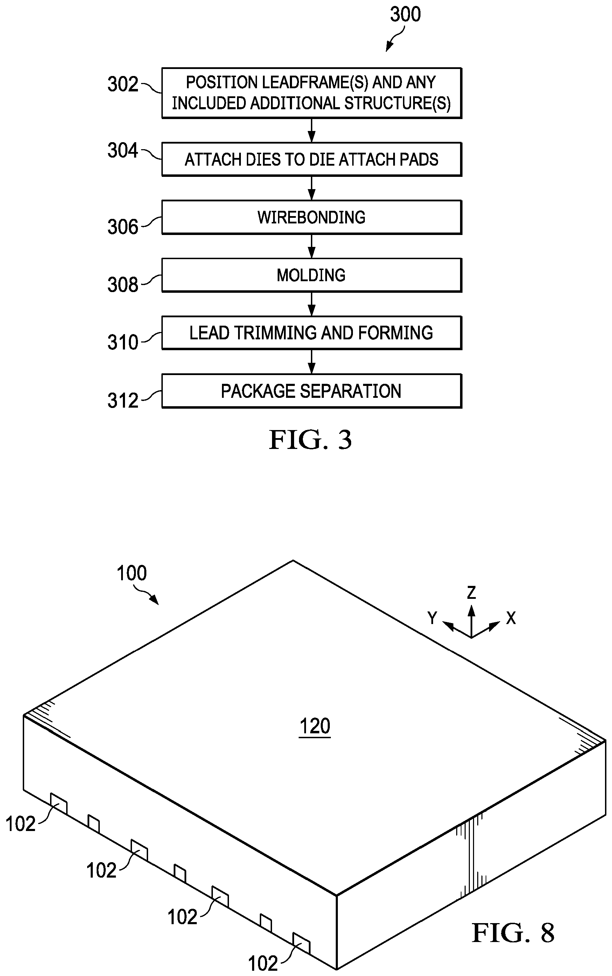

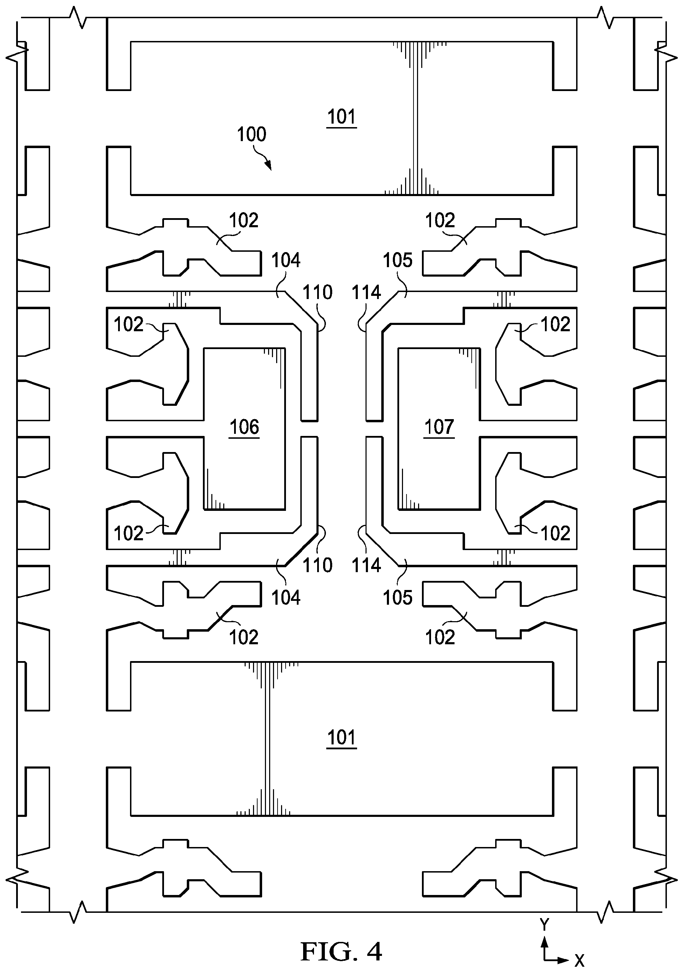

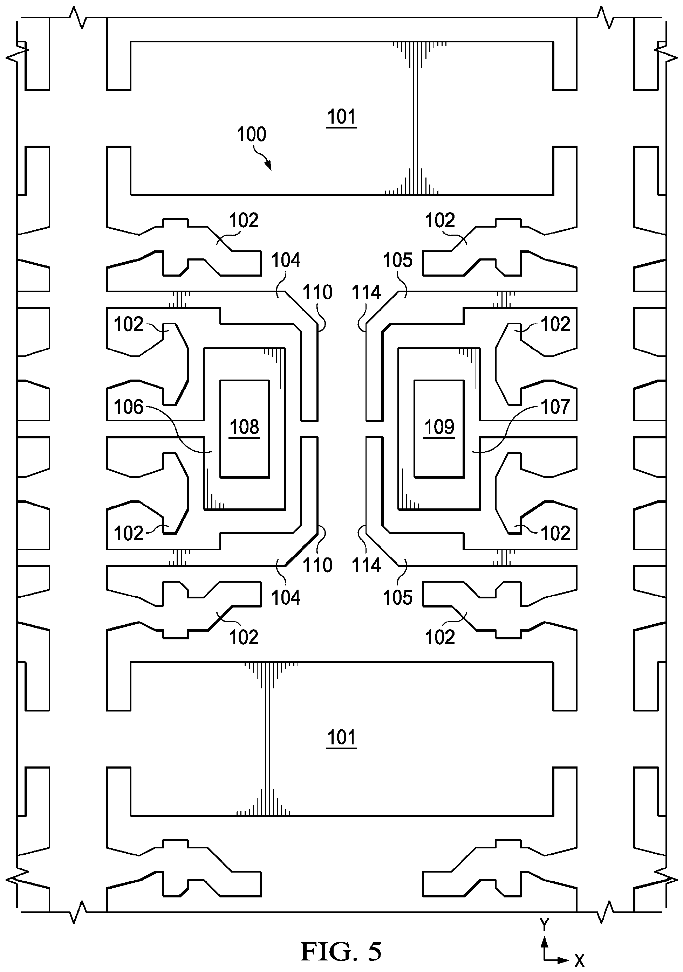

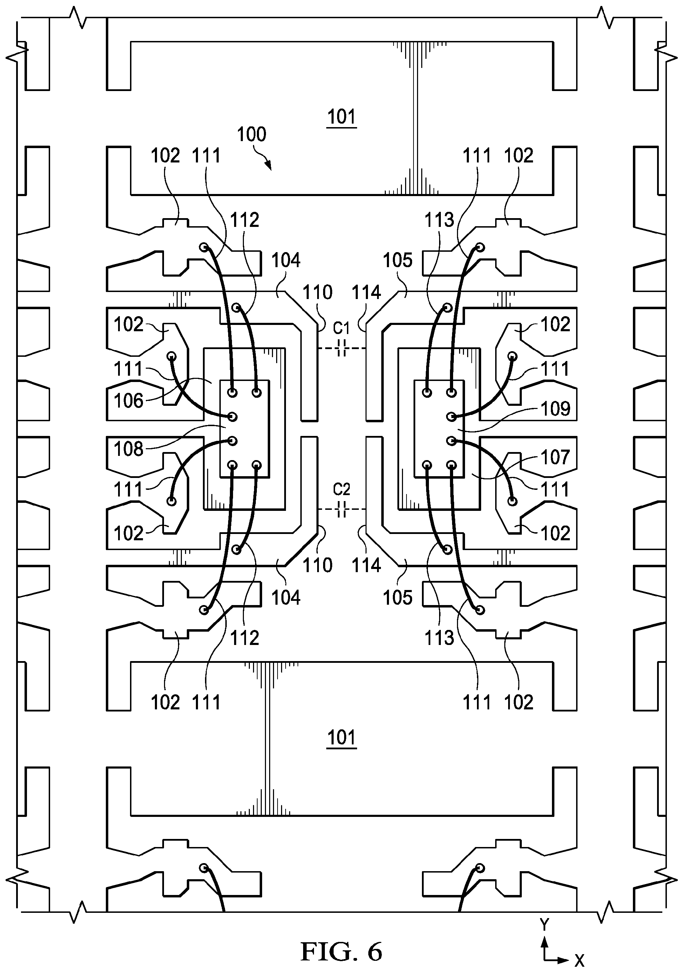

Referring also to FIGS. 3-7, FIG. 3 shows a method 300 of fabricating a packaged electronic device, and FIGS. 4-7 show the packaged electronic device example 100 of FIG. 1 at different stages of fabrication according to the method 300. The method 300 begins at 302 in FIG. 3 with positioning one or more lead frames, for example, the lead frame 101 in FIG. 4, such that the first side 110 of the first conductive plate 104 is spaced apart from and directly faces the second side 114 of the second conductive plate 105, no other side of the first conductive plate 104 directly faces a side of the second conductive plate 105, and no other side of the second conductive plate 105 directly faces a side of the first conductive plate 104. A die attach process is performed at 304, which attaches the first die 108 to the first die attach pad 106, and attaches the second die 109 to the second die attach pad 107, as shown in FIG. 5. The method 300 continues at 306 with performing a connection process. In one example shown in FIG. 6, the connection process is a wire bonding process that electrically connects the first bond wire 112 to the first die 108 and to the first conductive plate 104. The wire bonding process also electrically connects the second bond wire 113 to the second die 109 and to the second conductive plate 105. In the example of FIG. 6, the wire bonding process at 306 interconnects multiple bond wires 111, 112 and 113 between conductive features (e.g., bond pads) of the dies 108 and 109 with the leads 102 and/or the conductive plates 104 and 105 to form electrical circuit that includes the isolation capacitors C1 and C2.

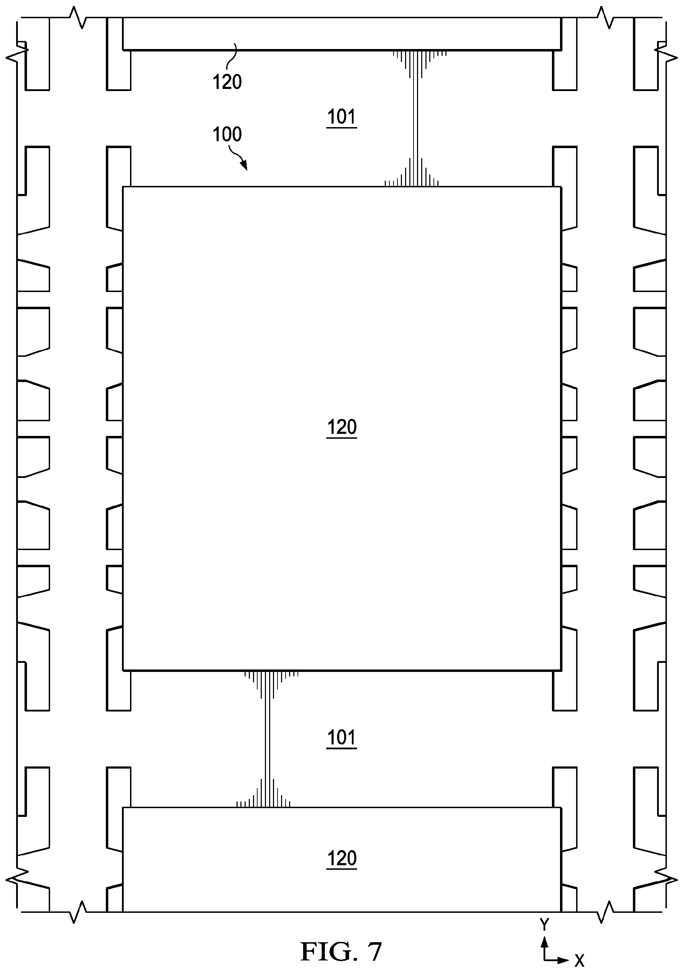

The method 300 continues at 308 in FIG. 3 with a molding process that forms the molded package structure 120. In the example of FIG. 7, the molding process creates separate molded package structures 120 for each prospective electronic device region of the lead frame assembly. The individual package structures 120 in this example each enclose the first die 108, the second die 109, the first bond wire 112, the second bond wire 112, a portion of the first conductive plate 104, and a portion of the second conductive plate 105. Certain examples also include lead trimming and forming operations at 310 in FIG. 3, although not a strict requirement of all possible implementations. At 312, the method 300 further includes separating the first conductive plate 104, the second conductive plate 105, and the conductive leads 102 from a remaining portion of the lead frame 101, for example, using laser cutting or sawing. FIG. 8 shows an example of the separated packaged electronic device 100.

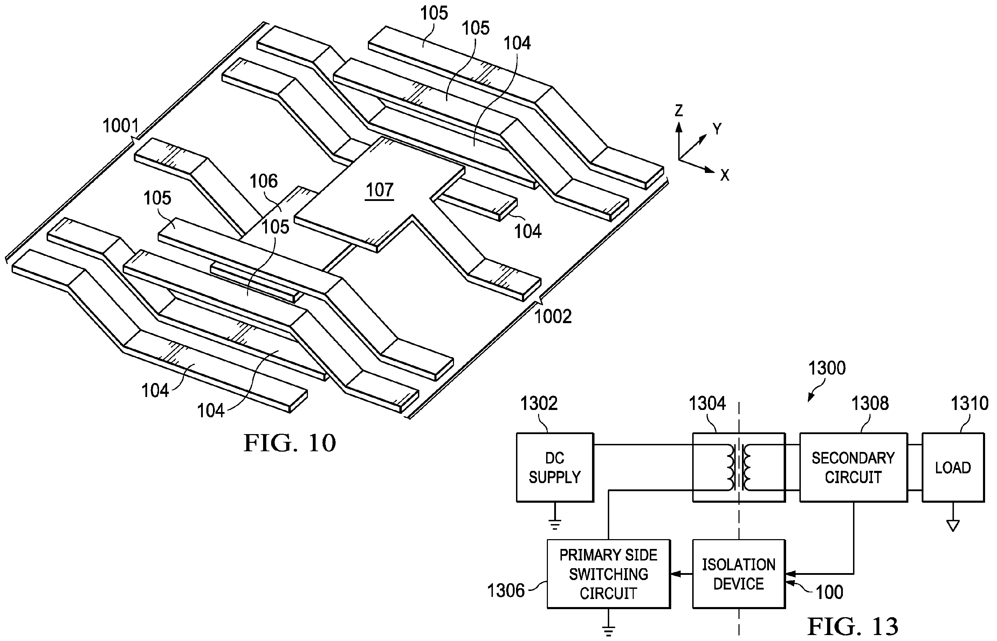

Referring also to FIGS. 9 and 10, another example packaged electronic device 900 in FIG. 9 includes lead frame-based isolation capacitors formed through the arrangement and positioning of conductive plates 104 and 105 of respective first and second starting lead frames 1001 and 1002 shown in FIG. 10. This example provides vertical capacitor plate spacing along the Z direction, in which the respective first conductive plates 104 of the first lead frame 1001 have upwardly facing, generally planar first sides, and the corresponding respective second conductive plates 105 of the second lead frame 1002 have downwardly facing, generally planar second sides. The electronic device 900 in this example includes the above-described leads 102, die attach pads 106 and 107, semiconductor dies 108 and 109, and molded package structure 120, as well as bond wires (not shown in FIGS. 9) to provide interconnections between the dies 108 and the leads 102 and conductive plates 104 and 105 to form an electrical circuit with two isolated voltage domains and capacitor connections via four capacitors created by the four conductive plates 104 and the four conductive plates 105 respectively separated by the dielectric material of the package structure 120.

As with the electronic device 100 of FIG. 1, the downwardly facing second sides of each of the second conductive plates 105 is spaced apart from and directly faces the upwardly facing first side of the respective first conductive plate 104. In addition, no other side of the first conductive plates 104 directly faces a side of the respective second conductive plate 105, and no other side of the respective second conductive plates 105 directly faces a side of the respective first conductive plates 104. In the example of FIGS. 9 and 10, moreover, the package structure 120 has first and second opposite sides that are spaced apart from one another along the first direction X, and portions of the conductive leads 102 are exposed outside the package structure 120 along the respective first and second sides of the package structure 120. In addition, the conductive leads 102 are spaced from one another along the second direction Y along the respective first and second sides of the package structure 120. In this example, the second sides of the respective second conductive plates 105 are vertically spaced apart from the first sides of the respective first conductive plates 104 along the third direction Z that is perpendicular to the first direction X and to the second direction Y. In other implementations, first and second conductive plates are laterally spaced from one another, such as along the Y direction.

As shown in FIG. 10, the first conductive plates 104 each have a first portion having the first side, and a second portion joint to the first portion by a band, where the first and second portions of the respective first conductive plates 104 are non-coplanar. Similarly, the respective second conductive plates 105 have a first portion that includes the second side, as well as a second portion joint to the first portion by a bend, and the first and second portions of the respective second conductive plates 105 are non-coplanar. During fabrication (e.g., at 302 according to the example method 300 above), the first lead frame 1001 is positioned relative to the second lead frame 1002 as shown in FIG. 10 such that the first sides of the first conductive plates 104 of the first lead frame 1001 are spaced apart from and directly facing the respective second sides of the second conductive plate 105 of the second lead frame 1002, no other side of the first conductive plate 104 directly faces a side of the respective second conductive plate 105, and no other side of the second conductive plate 105 directly faces a side of the first conductive plate 104.

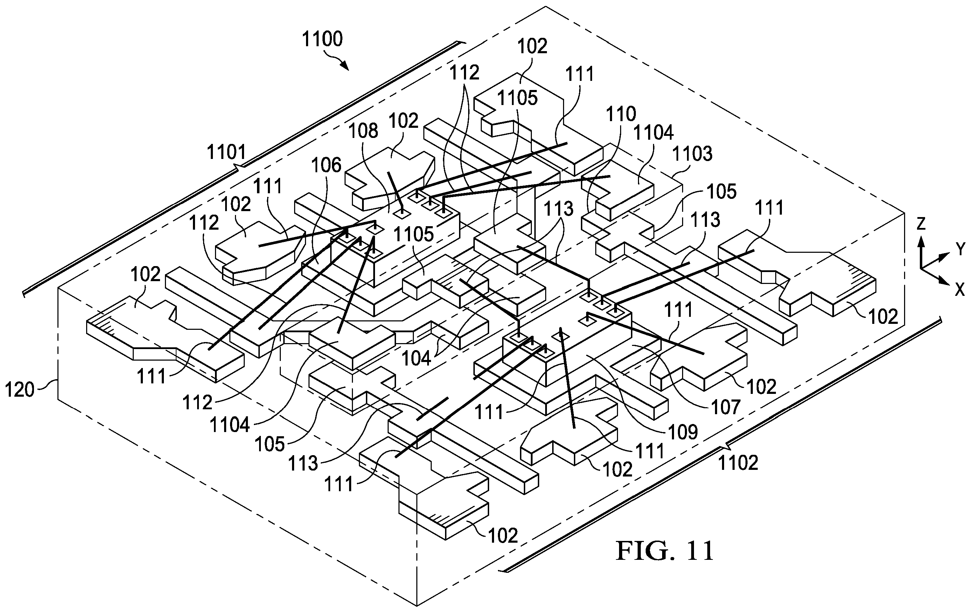

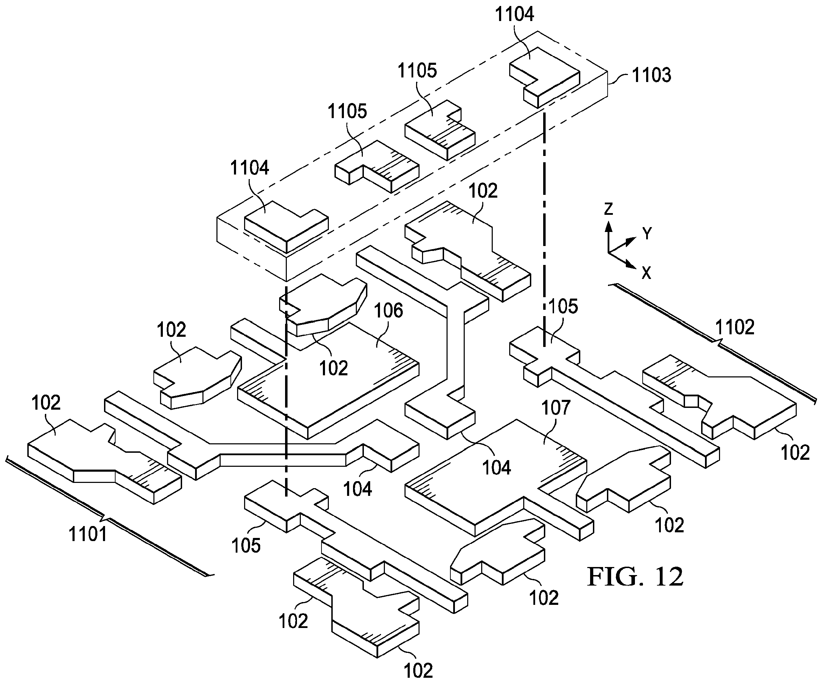

Referring also to FIGS. 11 and 12, FIG. 11 shows another example packaged electronic device 1100 with first and second semiconductor dies 108 and 109 and isolation capacitors with vertically spaced conductive plates from first and second starting lead frames 1101 and 1102, as well as a dielectric insert structure 1103 with additional respective first and second conductive capacitor plates 1104 and 1105. FIG. 12 shows the first and second starting lead frames 1101 and 1102 and the insert structure 1103 used in fabricating the packaged electronic device 1100 of FIG. 11. The insert structure 1103 in one example has respective first and second top side conductive plates 1104 and 1105 separated by a dielectric medium. The insert structure 1103, 1104, 1105 can be fabricated by a variety of techniques, including but not limited to dual level laminate construction, pre-molded lead frame (PMLF), MIS, etc. In various implementations, one or more of the first conductive plate 1104 and the second conductive plate 1105 is on or in the embedded dielectric insert 1103.

The electronic device 1100 has the above-described leads 102, die attach pads 106 and 107, semiconductor dies 108 and 109, and molded package structure 120, as well as bond wires 111, 112 and 113 to provide interconnections between the dies 108 and the leads 102 and conductive plates 104, 1104, 105 and 1105 to form an electrical circuit with two isolated voltage domains and capacitor connections via four capacitors created by the four conductive plates 104 and the four conductive plates 105 and the associated conductive plates 1104 and 1105 of the insert structure 1103, respectively separated by the dielectric material of the package structure 120. In this example, the package structure 120 has first and second opposite sides spaced apart from one another along the first direction X, and portions of the conductive leads 102 are exposed outside the package structure 120 along the respective first and second package structure sides. The conductive leads 102 in this example are spaced from one another along the second direction Y, and the second sides of the respective second conductive plates 105, 1105 are spaced apart from the first sides of the respective first conductive plates 104, 1104 along the third direction Z. This example also provides vertical capacitor plate spacing, although not a strict requirement of all possible implementations that use an insert structure.

During fabrication (e.g., at 302 according to the example method 300 above), the first lead frame 1101, the second lead frame 1102, and the dielectric insert structure 1103 are positioned relative to one another such that the first sides of the first conductive plates 104 of the first lead frame 1001 are spaced apart from and directly facing the respective second sides of the second conductive plates 1105 of the dielectric insert 1103, no other side of the first conductive plate 104 directly faces a side of the second conductive plate 1105, and no other side of the second conductive plate 1105 directly faces a side of the first conductive plate 104. The relative positioning at 302 in this example also provides that the first side of a third conductive plate 105 of the second lead frame 1102 is spaced apart from and directly faces a second side of a fourth conductive plate 1104 of the dielectric insert 1103, no other side of the third conductive plate 105 directly faces a side of the fourth conductive plate 1104, and no other side of the fourth conductive plate 1104 directly faces a side of the third conductive plate 105.

FIG. 13 shows a power conversion system 1300 with isolated primary and secondary circuits and a control or feedback signal path including the packaged electronic device 100 of FIG. 1. This example includes a DC supply 1302 with an output coupled to a first end of a primary winding of an isolation transformer 1304. A second end of the primary winding is coupled to a primary site switching circuit 1306. A secondary winding of the transformer 1304 is coupled to a secondary circuit 1308, for example, to implement a flyback switching power conversion system 1300. The secondary circuit 1308 is coupled to provide regulated output power to drive a load 1310. The electronic device 100 in this example is an isolation device that provides a feedback signal or a switching control signal from the secondary circuit 1308 two the primary side switching circuit 1306. In one example, the secondary circuit 1308 provides a signal to the isolation device 100 relative to an output or load side voltage domain, for example, representing a zero crossing of the switching circuit coupled to the secondary winding of the transformer 1304. In this example, the isolation device 100 provides an isolated signal to the primary site switching circuit 1306, and in response, the primary site switching circuit initiates a new switching cycle to close a switch to cause current flow in the primary winding of the transformer 1304. In another example, the secondary circuit 1308 provides a feedback signal to the isolation device 100 that represents an output voltage or output current of the load 1310, and the primary site switching circuit 1306 regulates the output voltage or current in closed-loop fashion according to the feedback signal from the isolation device 100.

The described examples provide a global low cost solution for signal isolation, with applicability across package types and footprints. These examples, moreover, can be used to provide high voltage isolation in a single package electronic device 100, 900, 1100 without requiring integration of capacitor isolation components on or in the semiconductor dies 108 and 109, thereby reducing the cost and complexity of the die fabrication. In addition, the described electronic devices 100, 900, 1100 provide integration within the packaged electronic device itself, thereby mitigating or avoiding the extra cost and board space associated with using opto-couplers or other external isolation components. The described examples provide signal isolation using lead frame metal structures for a solution that is silicon fabrication process agnostic. The resulting solutions, moreover, have much lower cost than integration of isolation components in a silicon fabrication process. The electronic devices 100, 900, and 1100, moreover, can be fabricated using existing lead frame manufacturing and assembly infrastructure and processes, allowing adaptation to a variety of different designs and use applications. These isolation solutions can be extended to all lead frame and/or laminate-based package types and form factors, while providing a robust isolation barrier. The described examples provide a technical solution to the previous problems of high cost, long cycle time and isolation technology based development limitations because of separate design, qualification, and certification requirements for each process node by removing isolation component dependency from silicon fabrication process nodes, and integrating the isolation solution into the lead frame itself.

Modifications are possible in the described examples, and other implementations are possible, within the scope of the claims.

## Claims

1. An electronic device, comprising:
a package structure (120);
conductive leads (102) partially exposed outside the package structure (120);
a first die (108) mounted to a first die attach pad in the package structure (120);
a second die (109) mounted to a second die attach pad in the package structure (120);
a first conductive plate (104) in the package structure (120), the first conductive plate (104) having a first side (110);
a second conductive plate (105) in the package structure (120), the second conductive plate (105) having a second side (114);
wherein the first side (110) of the first conductive plate (104) extends in a first plane; the second side (114) of the second conductive plate (105) extends in a second plane; the first and second planes are parallel to one another; and the first conductive plate (104) and the second conductive plate (105) are coplanar in a third plane that is perpendicular to the first and second planes;
a first bond wire (112) coupled to the first die (108) and to the first conductive plate (104) in the package structure (120); and
a second bond wire (113) coupled to the second die (109) and to the second conductive plate (105) in the package structure (120);
the second side (114) of the second conductive plate (105) being spaced apart from and directly facing the first side (110) of the first conductive plate (104), a portion of the package structure (120) extending between the first side (110) of the first conductive plate (104) and the second side (114) of the second conductive plate (105) to form a capacitor, no other side of the first conductive plate (104) directly facing a side of the second conductive plate (105), and no other side of the second conductive plate (105) directly facing a side of the first conductive plate (104).

2. The electronic device of claim 1, wherein: the package structure (120) has first and second opposite sides; the first and second sides of the package structure (120) are spaced apart from one another along a first direction; portions of the conductive leads (102) are exposed outside the package structure (120) along the respective first and second sides of the package structure (120); the conductive lead (102)s are spaced from one another along a second direction along the respective first and second sides of the package structure (120); the second direction is perpendicular to the first direction; and the second side (114) of the second conductive plate (105) is spaced apart from the first side (110) of the first conductive plate (104) along one of the first and second directions.

3. The electronic device of claim 1, wherein: the package structure (120) has first and second opposite sides; the first and second sides of the package structure (120) are spaced apart from one another along a first direction; portions of the conductive leads (102) are exposed outside the package structure (120) along the respective first and second sides of the package structure (120); the conductive leads (102) are spaced from one another along a second direction along the respective first and second sides of the package structure (120); the second direction is perpendicular to the first direction; and the second side (114) of the second conductive plate (105) is spaced apart from the first side (110) of the first conductive plate (104) along a third direction that is perpendicular to the first direction and to the second direction.

4. The electronic device of claim 3, wherein: the first conductive plate (104) has a first portion having the first side (110), and a second portion; and the first and second portions of the first conductive plate (104) are non-coplanar.

5. The electronic device of claim 4, wherein: the second conductive plate (105) has a first portion having the second side (114), and a second portion; and the first and second portions of the second conductive plate (105) are non-coplanar.

6. The electronic device of claim 3, further comprising an embedded dielectric insert in the package structure (120), wherein one of the first conductive plate (104) and the second conductive plate (105) is on or in the embedded dielectric insert.

7. The electronic device of claim 6, comprising multiple conductive plates on or in the embedded dielectric insert.

8. A method, comprising:
positioning a lead frame such that: a first side (110) of a first conductive plate (104) is spaced apart from and directly facing a second side (114) of a second conductive plate (105); no other side of the first conductive plate (104) directly faces a side of the second conductive plate (105); and no other side of the second conductive plate (105) directly faces a side of the first conductive plate (104);
performing a connection process that electrically connects a first bond wire (112) to a first die (108) and to the first conductive plate (104), and electrically connects a second bond wire (113) to a second die (109) and to the second conductive plate (105);
performing a molding process that forms a package structure (120) which encloses: the first die (108); the second die (109); the first bond wire (112); the second bond wire (113); a portion of the first conductive plate (104); and a portion of the second conductive plate (105); and
separating the first conductive plate (104), the second conductive plate (105), and conductive leads (102) from a remaining portion of the lead frame;
wherein positioning the lead frame comprises:
positioning a first lead frame relative to a second lead frame or relative to a dielectric insert such that: the first side (110) of the first conductive plate (104) of the first lead frame is spaced apart from and directly facing the second side (114) of the second conductive plate (105) of the second lead frame or of the dielectric insert; no other side of the first conductive plate (104) directly faces a side of the second conductive plate (105); and no other side of the second conductive plate (105) directly faces a side of the first conductive plate (104).

9. The method of claim 8 wherein positioning the lead frame comprises:
positioning the first lead frame relative to the dielectric insert such that: the first side (110) of the first conductive plate (104) of the first lead frame is spaced apart from and directly facing the second side (114) of the second conductive plate (105) of the dielectric insert; no other side of the first conductive plate (104) directly faces a side of the second conductive plate (105); and no other side of the second conductive plate (105) directly faces a side of the first conductive plate (104); and
positioning the second lead frame relative to the dielectric insert such that: a first side of a third conductive plate of the second lead frame is spaced apart from and directly facing a second side of a fourth conductive plate of the dielectric insert; no other side of the third conductive plate directly faces a side of the fourth conductive plate; and no other side of the fourth conductive plate directly faces a side of the third conductive plate.

10. The method of claim 8, wherein positioning the lead frame comprises:
positioning a first lead frame relative to a dielectric insert such that: the first side (110) of the first conductive plate (104) of the first lead frame is spaced apart from and directly facing the second side (114) of a second conductive plate (105) of the dielectric insert; no other side of the first conductive plate (104) directly faces a side of the second conductive plate (105); and no other side of the second conductive plate (105) directly faces a side of the first conductive plate (104); and
positioning a second lead frame relative to the dielectric insert such that: a first side of a third conductive plate of the second lead frame is spaced apart from and directly facing a second side of a fourth conductive plate of the dielectric insert; no other side of the third conductive plate directly faces a side of the fourth conductive plate; and no other side of the fourth conductive plate directly faces a side of the third conductive plate.

11. A system, comprising:
a first electronic circuit of a first voltage domain;
a second electronic circuit of a second voltage domain; and
an isolation device coupled with the first and second electronic circuits, the isolation device comprising:
a package structure (120);
a first set of conductive leads (102) partially exposed outside the package structure (120) and coupled to the first electronic circuit;
a second set of conductive leads (102) partially exposed outside the package structure (120) and coupled to the second electronic circuit;
a first die (108) mounted to a first die attach pad in the package structure (120) and coupled to the first set of conductive leads (102);
a second die (109) mounted to a second die attach pad in the package structure (120) and coupled to the second set of conductive leads (102);
a first conductive plate (104) in the package structure (120), the first conductive plate (104) having a first side (110);
a second conductive plate (105) in the package structure (120), the second conductive plate (105) having a second side (114);
the first side (110) of the first conductive plate (104) extends in a first plane; the second side (114) of the second conductive plate (105) extends in a second plane; the first and second planes are parallel to one another; and the first conductive plate (104) and the second conductive plate (105) are coplanar in a third plane that is perpendicular to the first and second planes;
a first bond wire (112) coupled to the first die (108) and to the first conductive plate (104) in the package structure (120); and
a second bond wire (113) coupled to the second die (109) and to the second conductive plate (105) in the package structure (120);
the second side (114) of the second conductive plate (105) being spaced apart from and directly facing the first side (110) of the first conductive plate (104), a portion of the package structure (120) extending between the first side (110) of the first conductive plate (104) and the second side (114) of the second conductive plate (105) to form a capacitor, no other side of the first conductive plate (104) directly facing a side of the second conductive plate (105), and no other side of the second conductive plate (105) directly facing a side of the first conductive plate (104).

12. The system of claim 11 , wherein: the first conductive plate (104) has a first portion having the first side (110), and a second portion; and the first and second portions of the first conductive plate (104) are non-coplanar.

13. The system of claim 11 , wherein the isolation device further comprises an embedded dielectric insert in the package structure (120), wherein one of the first conductive plate (104) and the second conductive plate (105) is on or in the embedded dielectric insert.

## Patentansprüche

1. Elektronische Vorrichtung, die Folgendes umfasst:
eine Gehäusestruktur (120);
leitfähige Zuleitungen (102), die teilweise außerhalb der Gehäusestruktur (120) freigelegt sind;
einen ersten Die (108), der an einem ersten Die-Befestigungspad in der Gehäusestruktur (120) montiert ist;
einen zweiten Die (109), der an einem zweiten Die-Befestigungspad in der Gehäusestruktur (120) montiert ist;
eine erste leitfähige Platte (104) in der Gehäusestruktur (120),
wobei die erste leitfähige Platte (104) eine erste Seite (110) aufweist;
eine zweite leitfähige Platte (105) in der Gehäusestruktur (120), wobei die zweite leitfähige Platte (105) eine zweite Seite (114) aufweist;
wobei sich die erste Seite (110) der ersten leitfähigen Platte (104) in einer ersten Ebene erstreckt; sich die zweite Seite (114) der zweiten leitfähigen Platte (105) in einer zweiten Ebene erstreckt; die erste und zweite Ebene parallel zueinander sind; und die erste leitfähige Platte (104) und die zweite leitfähige Platte (105) koplanar in einer dritten Ebene sind, die senkrecht zu der ersten und der zweiten Ebene ist;
einen ersten Bonddraht (112), der mit dem ersten Die (108) und mit der ersten leitfähigen Platte (104) in der Gehäusestruktur (120) gekoppelt ist; und
einen zweiten Bonddraht (113), der mit dem zweiten Die (109) und mit der zweiten leitfähigen Platte (105) in der Gehäusestruktur (120) gekoppelt ist; und
wobei die zweite Seite (114) der zweiten leitfähigen Platte (105) von der ersten Seite (110) der ersten leitfähigen Platte (104) beabstandet ist und dieser direkt zugewandt ist, wobei sich ein Teil der Gehäusestruktur (120) zwischen der ersten Seite (110) der ersten leitfähigen Platte (104) und der zweiten Seite (114) der zweiten leitfähigen Platte (105) erstreckt, um einen Kondensator zu bilden, wobei keine andere Seite der ersten leitfähigen Platte (104) direkt einer Seite der zweiten leitfähigen Platte (105) zugewandt ist und keine andere Seite der zweiten leitfähigen Platte (105) direkt einer Seite der ersten leitfähigen Platte (104) zugewandt ist.

2. Elektronische Vorrichtung nach Anspruch 1, wobei: die Gehäusestruktur (120) eine erste und eine zweite, gegenüberliegende Seite aufweist; die erste und die zweite Seite der Gehäusestruktur (120) entlang einer ersten Richtung voneinander beabstandet sind; Teile der leitfähigen Zuleitungen (102) außerhalb der Gehäusestruktur (120) entlang der jeweiligen ersten und zweiten Seite der Gehäusestruktur (120) freigelegt sind; die leitfähigen Zuleitungen (102) entlang einer zweiten Richtung entlang der jeweiligen ersten und zweiten Seite der Gehäusestruktur (120) voneinander beabstandet sind; die zweite Richtung senkrecht zu der ersten Richtung ist; und die zweite Seite (114) der zweiten leitfähigen Platte (105) entlang einer der ersten und zweiten Richtung von der ersten Seite (110) der ersten leitfähigen Platte (104) beabstandet ist.

3. Elektronische Vorrichtung nach Anspruch 1, wobei: die Gehäusestruktur (120) eine erste und eine zweite, gegenüberliegende Seite aufweist; die erste und die zweite Seite der Gehäusestruktur (120) entlang einer ersten Richtung voneinander beabstandet sind; Teile der leitfähigen Zuleitungen (102) außerhalb der Gehäusestruktur (120) entlang der jeweiligen ersten und zweiten Seite der Gehäusestruktur (120) freigelegt sind; die leitfähigen Zuleitungen (102) entlang einer zweiten Richtung entlang der jeweiligen ersten und zweiten Seite der Gehäusestruktur (120) voneinander beabstandet sind; die zweite Richtung senkrecht zu der ersten Richtung ist; und die zweite Seite (114) der zweiten leitfähigen Platte (105) entlang einer dritten Richtung, die senkrecht zu der ersten Richtung und zu der zweiten Richtung ist, von der ersten Seite (110) der ersten leitfähigen Platte (104) beabstandet ist.

4. Elektronische Vorrichtung nach Anspruch 3, wobei: die erste leitfähige Platte (104) einen ersten Teil mit der ersten Seite (110) und einen zweiten Teil aufweist; und der erste und zweite Teil der ersten leitfähigen Platte (104) nicht koplanar sind.

5. Elektronische Vorrichtung nach Anspruch 4, wobei: die zweite leitfähige Platte (105) einen ersten Teil mit der zweiten Seite (114) und einen zweiten Teil aufweist; und der erste und zweite Teil der zweiten leitfähigen Platte (105) nicht koplanar sind.

6. Elektronische Vorrichtung nach Anspruch 3, die ferner einen eingebetteten dielektrischen Einsatz in der Gehäusestruktur (120) umfasst, wobei sich entweder die erste leitfähige Platte (104) oder die zweite leitfähige Platte (105) auf oder in dem eingebetteten dielektrischen Einsatz befindet.

7. Elektronische Vorrichtung nach Anspruch 6, die mehrere leitfähige Platten auf oder in dem eingebetteten dielektrischen Einsatz umfasst.

8. Verfahren, das Folgendes umfasst:
Positionieren eines Leiterrahmens derart, dass: eine erste Seite (110) einer ersten leitfähigen Platte (104) von einer zweiten Seite (114) einer zweiten leitfähigen Platte (105) beabstandet ist und dieser direkt zugewandt ist; keine andere Seite der ersten leitfähigen Platte (104) direkt einer Seite der zweiten leitfähigen Platte (105) zugewandt ist; und keine andere Seite der zweiten leitfähigen Platte (105) direkt einer Seite der ersten leitfähigen Platte (104) zugewandt ist;
Durchführen eines Verbindungsprozesses, der einen ersten Bonddraht (112) elektrisch mit einem ersten Die (108) und mit der ersten leitfähigen Platte (104) verbindet und einen zweiten Bonddraht (113) elektrisch mit einem zweiten Die (109) und mit der zweiten leitfähigen Platte (105) verbindet;
Durchführen eines Vergussprozesses, der eine Gehäusestruktur (120) bildet, die Folgendes umschließt: den ersten Die (108); den zweiten Die (109); den ersten Bonddraht (112); den zweiten Bonddraht (113); einen Teil der ersten leitfähigen Platte (104); und einen Teil der zweiten leitfähigen Platte (105); und
Separieren der ersten leitfähigen Platte (104), der zweiten leitfähigen Platte (105) und der leitfähigen Zuleitungen (102) von einem verbleibenden Teil des Leiterrahmens;
wobei das Positionieren des Leiterrahmens Folgendes umfasst:
Positionieren eines ersten Leiterrahmens relativ zu einem zweiten Leiterrahmen oder relativ zu einem dielektrischen Einsatz, so dass: die erste Seite (110) der ersten leitfähigen Platte (104) des ersten Leiterrahmens von der zweiten Seite (114) der zweiten leitfähigen Platte (105) des zweiten Leiterrahmens oder des dielektrischen Einsatzes beabstandet ist und dieser direkt zugewandt ist; keine andere Seite der ersten leitfähigen Platte (104) einer Seite der zweiten leitfähigen Platte (105) direkt zugewandt ist; und keine andere Seite der zweiten leitfähigen Platte (105) einer Seite der ersten leitfähigen Platte (104) direkt zugewandt ist.

9. Verfahren nach Anspruch 8, wobei das Positionieren des Leiterrahmens Folgendes umfasst:
Positionieren des ersten Leiterrahmens relativ zu dem dielektrischen Einsatz, so dass: die erste Seite (110) der ersten leitfähigen Platte (104) des ersten Leiterrahmens von der zweiten Seite (114) der zweiten leitfähigen Platte (105) des dielektrischen Einsatzes beabstandet ist und dieser direkt zugewandt ist; keine andere Seite der ersten leitfähigen Platte (104) einer Seite der zweiten leitfähigen Platte (105) direkt zugewandt ist; und keine andere Seite der zweiten leitfähigen Platte (105) einer Seite der ersten leitfähigen Platte (104) direkt zugewandt ist; und
Positionieren des zweiten Leiterrahmens relativ zu dem dielektrischen Einsatz, so dass: eine erste Seite einer dritten leitfähigen Platte des zweiten Leiterrahmens von einer zweiten Seite einer vierten leitfähigen Platte des dielektrischen Einsatzes beabstandet ist und dieser direkt zugewandt ist; keine andere Seite der dritten leitfähigen Platte direkt einer Seite der vierten leitfähigen Platte zugewandt ist; und keine andere Seite der vierten leitfähigen Platte direkt einer Seite der dritten leitfähigen Platte zugewandt ist.

10. Verfahren nach Anspruch 8, wobei das Positionieren des Leiterrahmens Folgendes umfasst:
Positionieren eines ersten Leiterrahmens relativ zu einem dielektrischen Einsatz, so dass: die erste Seite (110) der ersten leitfähigen Platte (104) des ersten Leiterrahmens von der zweiten Seite (114) einer zweiten leitfähigen Platte (105) des dielektrischen Einsatzes beabstandet ist und dieser direkt zugewandt ist; keine andere Seite der ersten leitfähigen Platte (104) einer Seite der zweiten leitfähigen Platte (105) direkt zugewandt ist; und keine andere Seite der zweiten leitfähigen Platte (105) einer Seite der ersten leitfähigen Platte (104) direkt zugewandt ist; und
Positionieren eines zweiten Leiterrahmens relativ zu dem dielektrischen Einsatz, so dass: eine erste Seite einer dritten leitfähigen Platte des zweiten Leiterrahmens von einer zweiten Seite einer vierten leitfähigen Platte des dielektrischen Einsatzes beabstandet ist und dieser direkt zugewandt ist; keine andere Seite der dritten leitfähigen Platte direkt einer Seite der vierten leitfähigen Platte zugewandt ist; und keine andere Seite der vierten leitfähigen Platte direkt einer Seite der dritten leitfähigen Platte zugewandt ist.

11. System, das Folgendes umfasst:
einen ersten elektronischen Schaltkreis einer ersten Spannungsdomäne;
einen zweiten elektronischen Schaltkreis einer zweiten Spannungsdomäne; und
eine Isolationsvorrichtung, die mit dem ersten und dem zweiten elektronischen Schaltkreis gekoppelt ist, wobei die Isolationsvorrichtung Folgendes umfasst:
eine Gehäusestruktur (120);
einen ersten Satz leitfähiger Zuleitungen (102), die teilweise außerhalb der Gehäusestruktur (120) freigelegt sind und mit dem ersten elektronischen Schaltkreis gekoppelt sind;
einen zweiten Satz leitfähiger Zuleitungen (102), die teilweise außerhalb der Gehäusestruktur (120) freigelegt sind und mit dem zweiten elektronischen Schaltkreis gekoppelt sind;
einen ersten Die (108), der an einem ersten Die-Befestigungspad in der Gehäusestruktur (120) montiert und mit dem ersten Satz leitfähiger Zuleitungen (102) gekoppelt ist;
einen zweiten Die (109), der an einem zweiten Die-Befestigungspad in der Gehäusestruktur (120) montiert und mit dem zweiten Satz leitfähiger Zuleitungen (102) gekoppelt ist;
eine erste leitfähige Platte (104) in der Gehäusestruktur (120),
wobei die erste leitfähige Platte (104) eine erste Seite (110) aufweist;
eine zweite leitfähige Platte (105) in der Gehäusestruktur (120), wobei die zweite leitfähige Platte (105) eine zweite Seite (114) aufweist;
wobei sich die erste Seite (110) der ersten leitfähigen Platte (104) in einer ersten Ebene erstreckt; sich die zweite Seite (114) der zweiten leitfähigen Platte (105) in einer zweiten Ebene erstreckt; die erste und zweite Ebene parallel zueinander sind; und die erste leitfähige Platte (104) und die zweite leitfähige Platte (105) koplanar in einer dritten Ebene sind, die senkrecht zu der ersten und der zweiten Ebene ist;
einen ersten Bonddraht (112), der mit dem ersten Die (108) und mit der ersten leitfähigen Platte (104) in der Gehäusestruktur (120) gekoppelt ist; und
einen zweiten Bonddraht (113), der mit dem zweiten Die (109) und mit der zweiten leitfähigen Platte (105) in der Gehäusestruktur (120) gekoppelt ist; und
wobei die zweite Seite (114) der zweiten leitfähigen Platte (105) von der ersten Seite (110) der ersten leitfähigen Platte (104) beabstandet ist und dieser direkt zugewandt ist, wobei sich ein Teil der Gehäusestruktur (120) zwischen der ersten Seite (110) der ersten leitfähigen Platte (104) und der zweiten Seite (114) der zweiten leitfähigen Platte (105) erstreckt, um einen Kondensator zu bilden, wobei keine andere Seite der ersten leitfähigen Platte (104) direkt einer Seite der zweiten leitfähigen Platte (105) zugewandt ist und keine andere Seite der zweiten leitfähigen Platte (105) direkt einer Seite der ersten leitfähigen Platte (104) zugewandt ist.

12. System nach Anspruch 11, wobei: die erste leitfähige Platte (104) einen ersten Teil mit der ersten Seite (110) und einen zweiten Teil aufweist; und der erste und zweite Teil der ersten leitfähigen Platte (104) nicht koplanar sind.

13. System nach Anspruch 11, wobei die Isolationsvorrichtung ferner einen eingebetteten dielektrischen Einsatz in der Gehäusestruktur (120) umfasst, wobei sich entweder die erste leitfähige Platte (104) oder die zweite leitfähige Platte (105) auf oder in dem eingebetteten dielektrischen Einsatz befindet.

## Revendications

1. Dispositif électronique comprenant :
une structure de boîtier (120) ;
des pattes conductrices (102) partiellement exposées à l'extérieur de la structure de boîtier (120) ;
une première puce (108) montée sur une première plage de montage de puce dans la structure de boîtier (120) ;
une deuxième puce (109) montée sur une deuxième plage de montage de puce dans la structure de boîtier (120) ;
une première plaque conductrice (104) dans la structure de boîtier (120), la première plaque conductrice (104) ayant une première face (110) ;
une deuxième plaque conductrice (105) dans la structure de boîtier (120), la deuxième plaque conductrice (105) ayant une deuxième face (114) ;
où la première face (110) de la première plaque conductrice (104) s'étend dans un premier plan ; la deuxième face (114) de la deuxième plaque conductrice (105) s'étend dans un deuxième plan ; les premier et deuxième plans sont parallèles l'un à l'autre ; et la première plaque conductrice (104) et la deuxième plaque conductrice (105) sont coplanaires dans un troisième plan perpendiculaire aux premier et deuxième plans ;
un premier fil de liaison (112) couplé à la première puce (108) et à la première plaque conductrice (104) dans la structure de boîtier (120) ; et
un deuxième fil de liaison (113) couplé à la deuxième puce (109) et à la deuxième plaque conductrice (105) dans la structure de boîtier (120) ;
la deuxième face (114) de la deuxième plaque conductrice (105) étant espacée et directement en vis-à-vis de la première face (110) de la première plaque conductrice (104), une partie de la structure de boîtier (120) s'étendant entre la première face (110) de la première plaque conductrice (104) et la deuxième face (114) de la deuxième plaque conductrice (105) pour former un condensateur, aucune autre face de la première plaque conductrice (104) ne fait directement face à une face de la deuxième plaque conductrice (105) et aucune autre face de la deuxième plaque conductrice (105) ne fait directement face à une face de la première plaque conductrice (104).

2. Dispositif électronique selon la revendication 1, dans lequel : la structure de boîtier (120) a des première et deuxième faces opposées ; les première et deuxième faces de la structure de boîtier (120) sont espacées l'une de l'autre le long d'une première direction ; des parties des conducteurs (102) sont exposées à l'extérieur de la structure de boîtier (120) le long des première et deuxième faces respectives de la structure de boîtier (120) ; les conducteurs (102) sont espacés l'un de l'autre le long d'une deuxième direction le long des première et deuxième faces respectives de la structure de boîtier (120) ; la deuxième direction est perpendiculaire à la première direction ; et la deuxième face (114) de la deuxième plaque conductrice (105) est espacée de la première face (110) de la première plaque conductrice (104) le long d'une des première et deuxième directions.

3. Dispositif électronique selon la revendication 1, dans lequel : la structure de boîtier (120) a des première et deuxième faces opposées ; les première et deuxième faces de la structure de boîtier (120) sont espacées l'une de l'autre le long d'une première direction ; des parties des conducteurs (102) sont exposées à l'extérieur de la structure de boîtier (120) le long des première et deuxième faces respectives de la structure de boîtier (120) ; les conducteurs (102) sont espacés l'un de l'autre le long d'une deuxième direction le long des première et deuxième faces respectives de la structure de boîtier (120) ; la deuxième direction est perpendiculaire à la première direction ; et la deuxième face (114) de la deuxième plaque conductrice (105) est espacée de la première face (110) de la première plaque conductrice (104) le long d'une troisième direction qui est perpendiculaire aux première et deuxième directions.

4. Dispositif électronique selon la revendication 3, dans lequel : la première plaque conductrice (104) a une première partie ayant la première face (110), et une deuxième partie ; et les première et deuxième parties de la première plaque conductrice (104) sont non-coplanaires.

5. Dispositif électronique selon la revendication 4, dans lequel : la deuxième plaque conductrice (105) a une première partie ayant la deuxième face (114), et une deuxième partie ; et les première et deuxième parties de la deuxième plaque conductrice (105) sont non-coplanaires.

6. Dispositif électronique selon la revendication 3, comprenant en outre un insert diélectrique incorporé dans la structure de boîtier (120), où l'une de la première plaque conductrice (104) et de la deuxième plaque conductrice (105) est sur ou dans l'insert diélectrique incorporé.

7. Dispositif électronique selon la revendication 6, comprenant de multiples plaques conductrices sur ou dans l'insert diélectrique incorporé.

8. Procédé comprenant les étapes suivantes :
positionner une grille de connexion de telle sorte que : une première face (110) d'une première plaque conductrice (104) soit espacée et directement en vis-à-vis d'une deuxième face (114) d'une deuxième plaque conductrice (105) ; aucune autre face de la première plaque conductrice (104) ne fait directement face à une face de la deuxième plaque conductrice (105) ; et aucune autre face de la deuxième plaque conductrice (105) ne fait directement face à une face de la première plaque conductrice (104) ;
réaliser un processus de connexion qui connecte électriquement un premier fil de liaison (112) à une première puce (108) et à la première plaque conductrice (104), et connecte électriquement un deuxième fil de liaison (113) à une deuxième puce (109) et à la deuxième plaque conductrice (105) ;
réaliser un procédé de moulage qui forme une structure de boîtier (120) qui renferme : la première puce (108) ; la deuxième puce (109) ; le premier fil de liaison (112) ; le deuxième fil de liaison (113) ; une partie de la première plaque conductrice (104) ; et une partie de la deuxième plaque conductrice (105) ; et
séparer la première plaque conductrice (104), la deuxième plaque conductrice (105) et les conducteurs (102) d'une partie restante de la grille de connexion ;
où le positionnement de la grille de connexion comprend l'étape suivante :
positionner une première grille de connexion par rapport à une deuxième grille de connexion ou par rapport à un insert diélectrique de manière à ce que : la première face (110) de la première plaque conductrice (104) de la première grille de connexion soit espacée et directement en vis-à-vis de la deuxième face (114) de la deuxième plaque conductrice (105) de la deuxième grille de connexion ou de l'insert diélectrique ; aucune autre face de la première plaque conductrice (104) ne soit directement en regard d'une face de la deuxième plaque conductrice (105) ; et aucune autre face de la deuxième plaque conductrice (105) ne soit directement en regard d'une face de la première plaque conductrice (104).

9. Procédé selon la revendication 8, dans lequel le positionnement de la grille de connexion comprend les étapes suivantes :
positionner la première grille de connexion par rapport à l'insert diélectrique de manière à ce que : la première face (110) de la première plaque conductrice (104) de la première grille de connexion soit espacée et directement en regard de la deuxième face (114) de la deuxième plaque conductrice (105) de l'insert diélectrique ; aucune autre face de la première plaque conductrice (104) ne soit directement en regard d'une face de la deuxième plaque conductrice (105) ; et aucune autre face de la deuxième plaque conductrice (105) ne soit directement en regard d'une face de la première plaque conductrice (104) ; et
positionner la deuxième grille de connexion par rapport à l'insert diélectrique de manière à ce que : une première face d'une troisième plaque conductrice de la deuxième grille de connexion soit espacée et directement en regard d'une deuxième face d'une quatrième plaque conductrice de l'insert diélectrique ; aucune autre face de la troisième plaque conductrice ne soit directement en regard d'une face de la quatrième plaque conductrice ; et aucune autre face de la quatrième plaque conductrice ne soit directement en regard d'une face de la troisième plaque conductrice.

10. Procédé selon la revendication 8, dans lequel le positionnement de la grille de connexion comprend les étapes suivantes :
positionner une première grille de connexion par rapport à un insert diélectrique de manière à ce que : la première face (110) de la première plaque conductrice (104) de la première grille de connexion soit espacée et directement en regard de la deuxième face (114) d'une deuxième plaque conductrice (105) de l'insert diélectrique ; aucune autre face de la première plaque conductrice (104) ne soit directement en regard d'une face de la deuxième plaque conductrice (105) ; et aucune autre face de la deuxième plaque conductrice (105) ne soit directement en regard d'une face de la première plaque conductrice (104) ; et
positionner une deuxième grille de connexion par rapport à l'insert diélectrique de manière à ce que : une première face d'une troisième plaque conductrice de la deuxième grille de connexion soit espacée et directement en regard d'une deuxième face d'une quatrième plaque conductrice de l'insert diélectrique ; aucune autre face de la troisième plaque conductrice ne soit directement en regard d'une face de la quatrième plaque conductrice ; et aucune autre face de la quatrième plaque conductrice ne soit directement en regard d'une face de la troisième plaque conductrice.

11. Système comprenant :
un premier circuit électronique d'un premier domaine de tension ;
un deuxième circuit électronique d'un deuxième domaine de tension ; et
un dispositif d'isolation couplé aux premier et deuxième circuits électroniques, le dispositif d'isolation comprenant :
une structure de boîtier (120) ;
un premier ensemble de conducteurs (102) partiellement exposés à l'extérieur de la structure de boîtier (120) et couplés au premier circuit électronique ;
un deuxième ensemble de conducteurs (102) partiellement exposés à l'extérieur de la structure de boîtier (120) et couplés au deuxième circuit électronique ;
une première puce (108) montée sur une première plage de montage de puce dans la structure de boîtier (120) et couplée au premier jeu de conducteurs (102) ;
une deuxième puce (109) montée sur une deuxième plage de montage de puce dans la structure de boîtier (120) et couplée au deuxième jeu de conducteurs (102) ;
une première plaque conductrice (104) dans la structure de boîtier (120), la première plaque conductrice (104) ayant une première face (110) ;
une deuxième plaque conductrice (105) dans la structure de boîtier (120), la deuxième plaque conductrice (105) ayant une deuxième face (114) ;
la première face (110) de la première plaque conductrice (104) s'étendant dans un premier plan ; la deuxième face (114) de la deuxième plaque conductrice (105) s'étendant dans un deuxième plan ; les premier et deuxième plans étant parallèles l'un à l'autre ; et la première plaque conductrice (104) et la deuxième plaque conductrice (105) étant coplanaires dans un troisième plan perpendiculaire aux premier et deuxième plans ;
un premier fil de liaison (112) couplé à la première puce (108) et à la première plaque conductrice (104) dans la structure de boîtier (120) ; et
un deuxième fil de liaison (113) couplé à la deuxième puce (109) et à la deuxième plaque conductrice (105) dans la structure de boîtier (120) ;
la deuxième face (114) de la deuxième plaque conductrice (105) étant espacée et directement en vis-à-vis de la première face (110) de la première plaque conductrice (104), une partie de la structure de boîtier (120) s'étendant entre la première face (110) de la première plaque conductrice (104) et la deuxième face (114) de la deuxième plaque conductrice (105) pour former un condensateur, aucune autre face de la première plaque conductrice (104) ne fait directement face à une face de la deuxième plaque conductrice (105) et aucune autre face de la deuxième plaque conductrice (105) ne fait directement face à une face de la première plaque conductrice (104).

12. Système selon la revendication 11, dans lequel : la première plaque conductrice (104) a une première partie ayant la première face (110), et une deuxième partie ; et les première et deuxième parties de la première plaque conductrice (104) sont non-coplanaires.

13. Système selon la revendication 11, dans lequel le dispositif d'isolation comprend en outre un insert diélectrique incorporé dans la structure de boîtier (120), où l'une de la première plaque conductrice (104) et de la deuxième plaque conductrice (105) est sur ou dans l'insert diélectrique incorporé.
